(19) Europäisches Patentamt
European Patent Office
Office européen des brevets

(11) **EP 4 086 973 A1**

(12) **DEMANDE DE BREVET EUROPEEN**

(43) Date de publication:
**09.11.2022 Bulletin 2022/45**

(21) Numéro de dépôt: **22169761.8**

(22) Date de dépôt: **25.04.2022**

(51) Classification Internationale des Brevets (IPC):
**H01L 29/872** (2006.01)   **H01L 29/06** (2006.01)
**H02M 3/00** (2006.01)   **H02M 1/32** (2007.01)
**H02M 1/34** (2007.01)   **H02M 3/335** (2006.01)
**H01L 25/07** (2006.01)   *H01L 29/861* (2006.01)

(52) Classification Coopérative des Brevets (CPC):
**H01L 29/872; H01L 25/072; H01L 29/0603;
H02M 1/32; H02M 1/348; H02M 3/003;
H02M 3/33573;** H01L 29/8611; H02M 1/346

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**
Etats d'extension désignés:
**BA ME**
Etats de validation désignés:
**KH MA MD TN**

(30) Priorité: **07.05.2021 FR 2104856**

(71) Demandeur: **STMicroelectronics (Tours) SAS
37100 Tours (FR)**

(72) Inventeurs:
• **SIMONNET, Jean Michel
37270 VERETZ (FR)**
• **JOUVE, David
37360 SAINT-ANTOINE-DU-ROCHER (FR)**
• **LANOIS, Frederic
37100 TOURS (FR)**

(74) Mandataire: **Cabinet Beaumont
4, Place Robert Schuman
B.P. 1529
38025 Grenoble Cedex 1 (FR)**

(54) **DISPOSITIF DE SUPPRESSION DE TENSIONS TRANSITOIRES UNIDIRECTIONNEL SANS CONDUCTION EN DIRECT**

(57)    La présente description concerne un dispositif de suppression de tensions transitoires (10) comprenant un substrat semiconducteur monocristallin dopé d'un premier type de conductivité comprenant des première et deuxième faces opposées (14, 16), une région semiconductrice (18) dopée d'un deuxième type de conductivité opposé au premier type de conductivité s'étendant dans le substrat depuis la première face, une première électrode conductrice électriquement (20) sur la première face en contact avec la première région et une deuxième électrode conductrice électriquement (22) sur la deuxième face en contact avec le substrat, une première interface entre le substrat et la région semiconductrice formant la jonction d'une diode TVS et une deuxième interface entre la première électrode conductrice électriquement et la première région ou entre le substrat et la deuxième électrode conductrice électriquement formant la jonction d'une diode Schottky.

Fig 1

**Description**

Domaine technique

La présente description concerne de façon générale les dispositifs de suppression de tensions transitoires.

Technique antérieure

Un dispositif de suppression de tensions transitoires, également appelé dispositif TVS (sigle anglais pour transient-voltage-suppression), est un dispositif utilisé pour la protection d'un composant électronique ou de composants électroniques contre des pics de tension.

Un exemple de dispositif TVS est une diode de suppression de tensions transitoires, également appelée diode TVS. Il s'agit d'une diode réalisée dans un matériau semiconducteur qui limite les surtensions par effet avalanche dans le but exclusif de protection d'un circuit électronique. Une diode TVS peut être unidirectionnelle, c'est-à-dire avoir une tension de claquage en polarisation inverse et une tension de seuil en polarisation directe. Une diode TVS peut être bidirectionnelle, c'est-à-dire avoir des tensions de claquage symétriques ou non quel que soit le sens de polarisation.

Pour protéger un composant électronique contre les pics de tensions, le dispositif TVS peut être placé en parallèle du composant à protéger. Il est souhaitable que le dispositif TVS ne perturbe pas le fonctionnement normal du composant électronique qu'il protège. Toutefois, dans le cas où le dispositif TVS est une diode TVS unidirectionnelle, cette diode peut conduire le courant lorsqu'elle est polarisée en direct avec une tension suffisante et peut alors perturber le fonctionnement normal du composant électronique qu'elle protège.

Résumé de l'invention

Un mode de réalisation pallie tout ou partie des inconvénients des dispositifs de suppression de tensions transitoires connus.

Un mode de réalisation prévoit un dispositif de suppression de tensions transitoires comprenant un substrat semiconducteur monocristallin dopé d'un premier type de conductivité comprenant des première et deuxième faces opposées, une région semiconductrice dopée d'un deuxième type de conductivité opposé au premier type de conductivité s'étendant dans le substrat depuis la première face, une première électrode conductrice électriquement sur la première face en contact avec la première région et une deuxième électrode conductrice électriquement sur la deuxième face en contact avec le substrat, une première interface entre le substrat et la région semiconductrice formant la jonction d'une diode TVS et une deuxième interface entre la première électrode conductrice électriquement et la première région ou entre le substrat et la deuxième électrode conductrice électriquement formant la jonction d'une diode Schottky.

Selon un mode de réalisation, la concentration de dopants du deuxième type de conductivité de la région semiconductrice est comprise entre $1.10^{16}$ at/cm$^3$ et $1.10^{17}$ at/cm$^3$ lorsque la deuxième interface est située entre la première électrode conductrice électriquement et la région semiconductrice et la concentration de dopants du deuxième type de conductivité de la région semiconductrice est comprise entre $1.10^{16}$ at/cm$^3$ et $1.10^{20}$ at/cm$^3$ lorsque la deuxième interface est située entre le substrat et la deuxième électrode conductrice électriquement.

Selon un mode de réalisation, la concentration de dopants du premier type de conductivité du substrat au niveau de la première interface est comprise entre $2.10^{14}$ at/cm$^3$ et $3.10^{16}$ at/cm$^3$ lorsque la deuxième interface est située entre la première électrode conductrice électriquement et la région semiconductrice et la concentration de dopants du premier type de conductivité du substrat au niveau de la première interface est comprise entre $2.10^{14}$ at/cm$^3$ et $1.10^{17}$ at/cm$^3$ lorsque la deuxième interface est située entre le substrat et la deuxième électrode conductrice électriquement.

Selon un mode de réalisation, le substrat comprend un empilement de première et deuxième portions, la première portion contenant la région semiconductrice et la deuxième portion étant au contact de la deuxième électrode conductrice électriquement, la concentration de dopants du premier type de conductivité de la première portion étant inférieure strictement à la concentration de dopants du premier type de conductivité de la deuxième portion.

Un mode de réalisation prévoit un circuit électronique comprenant :

- un support conducteur électriquement ;

- un composant électronique ayant des première et deuxième bornes, la deuxième borne étant fixée au support conducteur électriquement ; et

- le dispositif de suppression de tensions transitoires tel que défini précédemment, la deuxième électrode conductrice électriquement du dispositif de suppression de tensions transitoires étant fixée au support.

Selon un mode de réalisation, la première électrode conductrice électriquement du dispositif de suppression de tensions transitoires est connectée à la première borne du composant électronique.

Un mode de réalisation prévoit un circuit électronique comprenant au moins un composant électronique et un dispositif de suppression de tensions transitoires tel que défini précédemment, disposé en parallèle du composant électronique.

Selon un mode de réalisation, le circuit comprend au moins quatre composants électroniques montés en pont, et quatre dispositifs de suppression de tensions transitoires, chaque dispositif de suppression de tensions transitoires étant disposé en parallèle de l'un des composants électroniques.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe, partielle et schématique, d'un mode de réalisation d'un dispositif TVS ;

la figure 2 est une vue en coupe, partielle et schématique, d'une variante du dispositif TVS de la figure 1 ;

la figure 3 est une vue en coupe, partielle et schématique, d'une autre variante du dispositif TVS de la figure 1 ;

la figure 4 est une vue en coupe, partielle et schématique, d'une autre variante du dispositif TVS de la figure 1 ;

la figure 5 représente une courbe d'évolution du courant circulant dans le dispositif TVS de la figure 1 en fonction de la tension appliquée au dispositif TVS selon un premier sens de polarisation ;

la figure 6 représente une courbe d'évolution du courant circulant dans le dispositif TVS de la figure 1 en fonction de la tension appliquée au dispositif TVS selon un deuxième sens de polarisation ;

la figure 7 est un schéma électrique illustrant un exemple de montage du dispositif TVS pour la protection d'un composant électronique ;

la figure 8 est une vue en coupe, partielle et schématique, d'un mode de réalisation d'un circuit électronique selon le schéma électrique de la figure 7 ;

la figure 9 est une vue en coupe, partielle et schématique, d'un autre mode de réalisation d'un dispositif TVS ;

la figure 10 est une vue en coupe, partielle et schématique, d'une variante du dispositif TVS de la figure 9 ;

la figure 11 est un schéma électrique d'un exemple de convertisseur de tension continu-continu ;

la figure 12 représente des chronogrammes de tensions et de courants du convertisseur de la figure 11 ;

la figure 13 est un schéma électrique d'un exemple de convertisseur de tension continu-continu dont des composants sont protégés par des diodes TVS ;

la figure 14 représente des chronogrammes de tensions et de courants du convertisseur de la figure 13 ;

la figure 15 est un schéma électrique d'un exemple de convertisseur de tension continu-continu dont des composants sont protégés par des dispositifs TVS tels que représentés en figure 1 et décrits ; et

la figure 16 représente des chronogrammes de tensions et de courants du convertisseur de la figure 15.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques. Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments. En outre, on considère ici que les termes "isolant" et "conducteur" signifient respectivement "isolant électriquement" et "conducteur électriquement".

Dans la description qui suit, lorsque l'on fait référence à des qualificatifs de position relative, tels que les termes "dessus", "dessous", "supérieur", "inférieur", etc., il est fait référence sauf précision contraire à l'orientation des figures ou à un dispositif électronique dans une position normale d'utilisation. Sauf précision contraire, les expressions "environ", "approximativement", "sensiblement", et "de l'ordre de" signifient à 10 % près, de préférence à 5 % près.

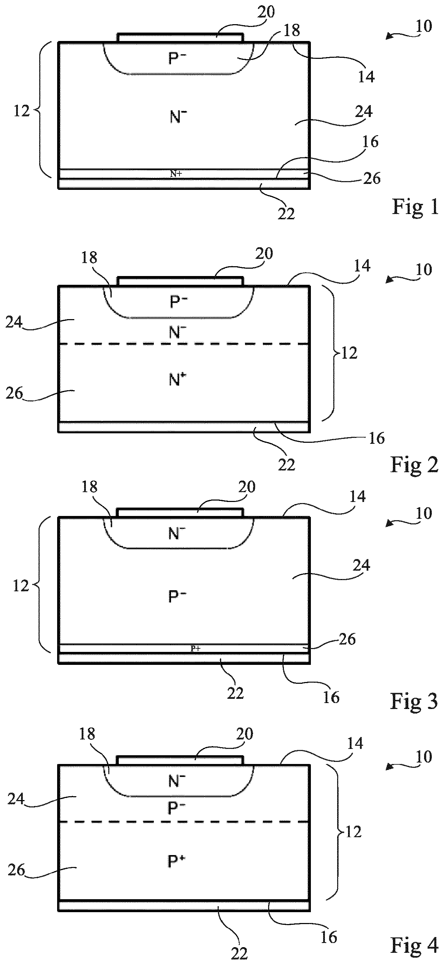

La figure 1 est une vue en coupe, partielle et schématique, d'un mode de réalisation d'un dispositif TVS 10. Les figures 2, 3, et 4 sont des vues en coupe, partielles et schématiques, de variantes du dispositif TVS 10.

Sur les figures 1 à 4, le dispositif TVS 10 comprend :

- un substrat semiconducteur 12, de préférence un substrat en silicium monocristallin dopé d'un premier type de conductivité ayant une face supérieure 14 et une face inférieure 16, se divisant en une portion supérieure 24 faiblement dopée du premier type de conductivité du côté de la face supérieure 14 et une portion inférieure 26 fortement dopée du premier type de conductivité du côté de la face inférieure 16 ;

- une région 18 faiblement dopée d'un deuxième type de conductivité, opposé au premier type de conductivité, s'étendant dans la portion supérieure 24 du substrat 12 depuis la face supérieure 14 ;

- une électrode supérieure 20, par exemple métallique, reposant sur la face supérieure 14 au contact de la région 18 ; et

- une électrode inférieure 22, par exemple métallique, reposant sur la face inférieure 16 au contact du substrat 12.

Selon un mode de réalisation, les faces 14 et 16 sont planes. Selon un mode de réalisation, les faces 14 et 16 sont parallèles. Selon un mode de réalisation, l'épaisseur du substrat 12, c'est-à-dire la distance entre les faces 14 et 16, est comprise entre 60 $\mu$m et 300 $\mu$m, de préférence entre 90 $\mu$m et 300 $\mu$m, plus préférentiellement entre 150 $\mu$m et 300 $\mu$m. La région 18 peut être formée par une étape d'implantation de dopants du deuxième type de conductivité dans le substrat 12.

Pour le dispositif TVS 10 des figures 1 et 3, la portion supérieure 24 faiblement dopée du premier type de conductivité forme l'essentiel du substrat 12, la portion inférieure 26 ayant par exemple une épaisseur inférieure à 5 % de l'épaisseur totale du substrat 12. La portion inférieure 26 fortement dopée du premier type de conductivité peut être formée par une étape d'implantation de dopants du premier type de conductivité du côté de la face inférieure 16. La concentration de dopants du premier type de conductivité dans le substrat 12 en dehors de la région 18 et de la portion inférieure 26 est sensiblement constante. Pour le dispositif TVS 10 des figures 2 et 4, l'épaisseur de la portion inférieure 26 fortement dopée du premier type de conductivité est supérieure à 10 % de l'épaisseur totale du substrat 12. Selon un mode de réalisation, la portion supérieure 24 du substrat 12 est formée par épitaxie sur la portion inférieure 26 du substrat 12.

Pour le dispositif TVS 10 des figures 1 et 2, le premier type de conductivité est le type N et le deuxième type de conductivité est le type P. La concentration de dopants de type P de la région 18 est comprise entre $1.10^{16}$ at/cm$^3$ et $1.10^{17}$ at/cm$^3$. Selon un mode de réalisation, l'épaisseur maximale de la région 18 est comprise entre 1 $\mu$m et 40 $\mu$m. La concentration de dopants de type N dans la portion supérieure 24 du substrat 12 en dehors de la région 18 est comprise entre $2.10^{14}$ at/cm$^3$ et $3.10^{16}$ at/cm$^3$. La concentration de dopants dans la portion inférieure 26 du substrat 12 fortement dopée de type N est comprise entre $8.10^{18}$ at/cm$^3$ et $8.10^{19}$ at/cm$^3$. Pour la variante de la figure 2, l'épaisseur de la portion supérieure 24 du substrat 12, mesurée depuis la face supérieure 14, est comprise entre 5 $\mu$m et 100 $\mu$m.

Pour le dispositif TVS 10 des figures 3 et 4, le premier type de conductivité est le type P et le deuxième type de conductivité est le type N. La concentration de dopants de type N de la région 18 est comprise entre $1.10^{16}$ at/cm$^3$ et $1.10^{17}$ at/cm$^3$. Selon un mode de réalisation, l'épaisseur maximale de la région 18 est comprise entre 1 $\mu$m et 40 $\mu$m. La concentration de dopants de type P dans la portion supérieure 24 du substrat 12 en dehors de la région 18 est comprise entre $2.10^{14}$ at/cm$^3$ et $3.10^{16}$ at/cm$^3$. La concentration de dopants dans la portion inférieure 26 du substrat 12 fortement dopée de type P est comprise entre $8.10^{18}$ at/cm$^3$ et $8.10^{19}$ at/cm$^3$. Pour la variante de la figure 4, l'épaisseur de la portion supérieure 24 du substrat 12, mesurée depuis la face supérieure 14 est comprise entre 5 $\mu$m et 100 $\mu$m.

Le dispositif TVS 10 représenté sur les figures 1 à 4 se comporte comme la mise en anti-série entre deux bornes d'une diode TVS et d'une diode Schottky réalisées de façon intégrée dans un seul substrat semiconducteur. Les bornes correspondent aux électrodes 20 et 22. L'interface entre l'électrode 20 et la région 18 faiblement dopée du second type de conductivité forme la jonction de la diode Schottky. La jonction entre la région 18 faiblement dopée du second type de conductivité et la partie du substrat 12 adjacente faiblement dopée du premier type de conductivité forme la jonction de la diode TVS. L'électrode inférieure 22 forme un contact ohmique avec le substrat 12.

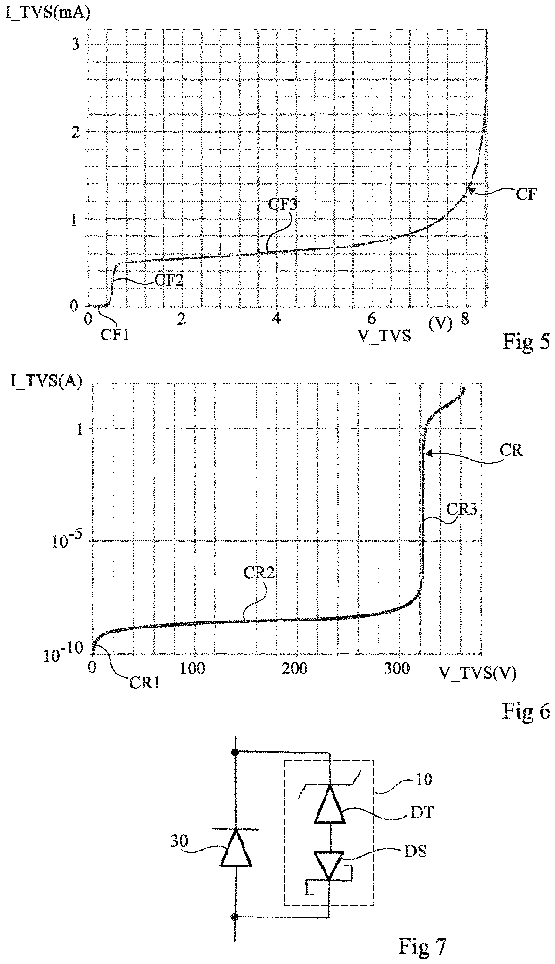

La figure 5 représente une courbe CF d'évolution du courant I_TVS circulant de l'électrode 20 vers l'électrode 22 du dispositif TVS 10 de la figure 2 en fonction de la tension V_TVS entre l'électrode 20 et l'électrode 22. Pour les simulations, l'épaisseur de la portion supérieure 24 du substrat 12 était de 18 $\mu$m et l'épaisseur de la portion inférieure 26 du substrat 12 était de 10 $\mu$m. La courbe CF a été obtenue par simulation avec une concentration maximale de dopants de type P (présentant un profil gaussien) de la région 18 égale à $3,7.10^{16}$ cm$^3$, une concentration de dopants de type N de la portion supérieure 24 du substrat 12 égale à $9.10^{14}$ cm$^3$, et une concentration de dopants de type N de la portion inférieure 26 du substrat 12 égale à $2.10^{19}$ cm$^3$.

Ceci correspond à une polarisation en direct de la diode TVS du dispositif TVS 10 et une polarisation en inverse de la diode Schottky du dispositif TVS 10. La courbe CF comprend successivement une partie CF1 pour laquelle le courant I_TVS est sensiblement nul, une partie CF2 pour laquelle le courant I_TVS augmente rapidement avec la tension V_TVS lorsque la diode TVS polarisée en direct du dispositif TVS 10 devient passante et que le courant de saturation de la diode Schottky n'a pas été atteint, et une partie CF3 pour laquelle le courant I_TVS correspond sensiblement au courant de fuite en inverse de la diode Schottky du dispositif TVS 10 et augmente avec la tension appliquée aux bornes de la diode Schottky polarisée en inverse du dispositif TVS 10. De préférence, les tensions appliquées au dispositif TVS 10 correspondant à une polarisation en inverse de la diode Schottky du dispositif TVS 10 sont inférieures à la tension de claquage inverse de la diode Schottky qui peut être de l'ordre de 1 V à 20 V, selon le dopage et l'épaisseur de la région 18.

La figure 6 représente une courbe CR d'évolution du courant I_TVS circulant de l'électrode 22 vers l'électrode 20 du dispositif TVS 10 de la figure 1 en fonction de la tension V_TVS entre l'électrode 22 et l'électrode 20. La courbe CR a été obtenue par simulation avec les mêmes concentrations de dopants que la courbe CF.

Ceci correspond à une polarisation en inverse de la diode TVS du dispositif TVS 10 et une polarisation en direct de la diode Schottky du dispositif TVS 10. La courbe CR comprend successivement une partie CR1 pour laquelle le courant I_TVS augmente rapidement avec la tension V_TVS, ce et une partie CR2 pour laquelle le courant I_TVS augmente plus lentement avec la tension V_TVS, et une partie CR3 pour laquelle le courant I_TVS augmente très rapidement avec la tension V_TVS. Les parties CR1 et CR2 correspondent à un accroissement du courant de fuite de la diode TVS dû à l'élargissement de la zone de charge d'espace. La différence de croissance du courant entre les parties CR1 et CR2 tient à l'élargissement de la zone de charge d'espace. La partie CR3 correspond au fonctionnement en mode avalanche de la diode TVS du dispositif TVS 10. Comme le courant de saturation Isat_Sch de la diode Schottky est très supérieur au courant de fuite I_TVS de la diode TVS, la diode Schottky présente une tension très faible à ces bornes qui n'affecte pas la caractéristique électrique de la diode TVS avant son passage dans l'avalanche. La tension V_Schottky sur la diode Schottky peut s'écrire selon la relation suivante :

$$V\_Schottky = (kT/q)*ln(I\_TVS/Isat\_Sch+1) \qquad (1)$$

où k est la constante de Boltzmann, T la température absolue, et q la charge électrique de l'électron.

Pour I_TVS très inférieur à Isat_Sch, la tension V_Schottky est approximativement égale à kT/q*I_TVS/Isat_Sch qui vaut au plus quelques millivolts et est donc négligeable par rapport à la tension aux bornes de la diode TVS. De ce fait, la tension V_TVS aux bornes du dispositif TVS 10, qui est égale à la somme de la tension V_Schottky aux bornes de la diode Schottky et de la tension aux bornes de la diode TVS, est approximativement égale à la tension aux bornes de la diode TVS. Lorsque le courant devient supérieur à Isat_Sch, la tension sur la diode Schottky croit d'environ 60 mV par décade de courant qui viennent s'ajouter à la tension sur la diode TVS. Cette tension correspond à la tension de seuil de la diode Schottky et est en général inférieure à 1 V. Dans la plupart des cas, cette tension sera négligeable par rapport à la tension d'avalanche de la diode TVS. La présence de la diode Schottky n'affecte donc que très peu la caractéristique de la diode TVS.

Les variantes du dispositif TVS 10 représentées sur les figures 2 et 4 permettent de façon avantageuse de réduire la résistance série du dispositif TVS 10 entre les bornes 20 et 22 en raison de la portion inférieure 26 fortement dopée du substrat 12 qui a une résistivité réduite. Ces variantes peuvent ainsi avoir une capacité de dissipation de puissance augmentée. Ces variantes, dissipant moins de puissance pour un impulsion donnée, pourront supporter des surcharges en courant plus élevées.

La figure 7 est un schéma illustrant un exemple de montage du dispositif TVS 10 pour la protection d'un composant électronique 30, en figure 7 une diode. De façon générale, le composant électronique 30 à protéger est par exemple une diode, une diode Schottky, une diode en carbure de silicium (SiC), un transistor MOS de puissance avec une diode intrinsèque, ou un transistor bipolaire à grille isolée (IGBT) avec une diode externe en antiparallèle. Selon un mode de réalisation, le dispositif TVS 10 est placé en parallèle du composant électronique 30 à protéger. On a représenté de façon schématique en figure 7 le dispositif TVS 10 par une diode TVS DT en anti-série avec une diode Schottky DS.

Le dispositif TVS 10 est orienté de façon que la diode TVS DT du dispositif TVS 10 soit polarisée en direct lorsque le composant électronique 30 conduit un courant d'intensité maximale en fonctionnement normal. Dans le cas où le composant électronique 30 est une diode, le dispositif TVS 10 est orienté de façon que la diode TVS DT du dispositif TVS 10 soit polarisée en direct lorsque le composant électronique 30 est polarisé en direct.

De ce fait, lorsque le composant électronique 30 conduit un courant d'intensité maximale en fonctionnement normal, la diode Schottky du dispositif TVS 10 bloque le passage du courant dans le dispositif TVS 10 de sorte que le dispositif TVS 10 ne perturbe pas le fonctionnement normal du composant 30. Dans le cas où se produit un pic de tension inverse, la diode TVS du dispositif TVS 10 écrête la tension et protège ainsi le composant 30.

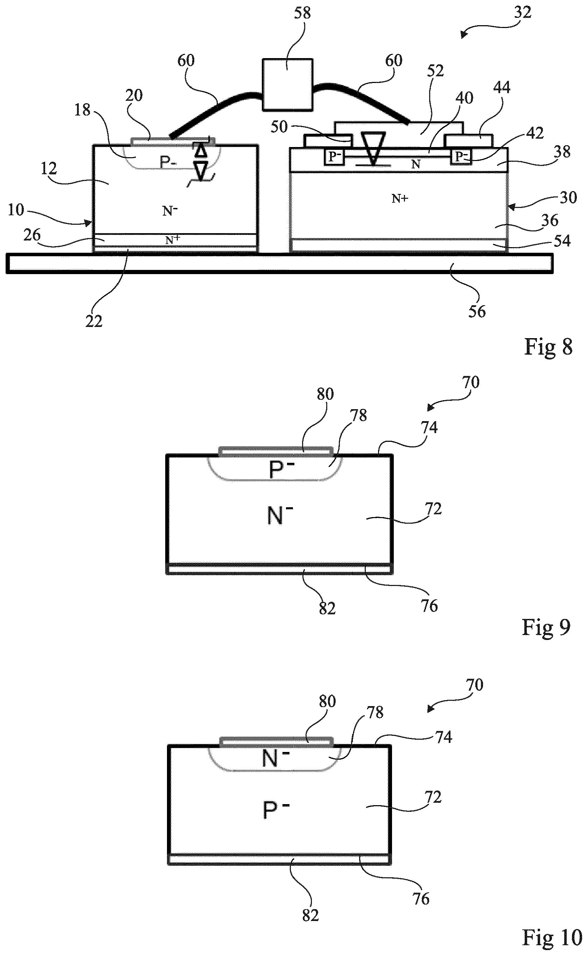

La figure 8 est une vue en coupe, partielle et schématique, d'un mode de réalisation intégrée dans un même boitier d'un circuit électronique 32 correspondant au schéma électrique de la figure 7, et comprenant le dispositif TVS 10 connecté en parallèle du composant électronique 30 correspondant à une diode. A titre d'exemple, la diode 30 comprend :

- un substrat semiconducteur 36, par exemple un substrat en silicium monocristallin dopé de type N ;

- une couche 38 de silicium dopée de type N formée par épitaxie sur le substrat 36 ;

- une région 40 dopée de type P formée dans la couche 38 ;

- une région 42 annulaire formée dans la couche 38 et entourant la région 40, dopée de type P et plus faiblement dopée que la région 40 ;

- une couche isolante 44 recouvrant la région annulaire 42 et délimitant une ouverture 50 exposant une partie de la région 40 ;

- une électrode conductrice électriquement 52 au contact de la région 40 dans l'ouverture 50 ; et

- une électrode 54 métallique sur le côté du substrat 36 opposé à la couche 38.

Le circuit 32 comprend en outre un support conducteur 56 sur lequel sont fixés le dispositif TVS 10 et la diode 30, l'électrode inférieure 22 du dispositif TVS 10 étant fixée au support 56, et l'électrode 54 de la diode 30 étant fixée au support 56. Le support 56 forme une cathode commune à la diode 30 et à la diode TVS du dispositif TVS 10. Le circuit 32 comprend en outre un plot conducteur 58, représenté schématiquement à des fins d'illustration par un carré au-dessus du dispositif TVS 10 et de la diode 30, connecté à l'électrode supérieure 20 du dispositif TVS 10 et à l'électrode 52 de la diode 30, par exemple par des fils 60.

Le circuit électronique 32 intègre donc sur un même support 56 le dispositif TVS 10 et le composant électronique 30 à protéger. Ceci permet de réduire les inductances parasites entre le dispositif TVS 10 et le composant électronique 30, améliorant ainsi la protection du composant électronique 30.

De plus, l'utilisation du dispositif TVS 10 intégrant une diode TVS et une diode Schottky est plus simple que la réalisation d'une protection avec une diode TVS et une diode Schottky sous forme de composants discrets.

La figure 9 est une vue en coupe, partielle et schématique, d'un autre mode de réalisation d'un dispositif TVS 70. La figure 10 est une vue en coupe, partielle et schématique, d'une variante du dispositif TVS 70.

Sur les figures 9 et 10, le dispositif TVS 70 comprend :

- un substrat semiconducteur 72, de préférence un substrat en silicium monocristallin faiblement dopé d'un premier type de conductivité ayant une face supérieure 74 et une face inférieure 76 ;

- une région 78 dopée d'un deuxième type de conductivité, opposé au premier type de conductivité, s'étendant dans le substrat 72 depuis la face supérieure 74 sur une partie de l'épaisseur du substrat 72 ;

- une électrode supérieure conductrice électriquement 80, par exemple métallique, reposant sur la face supérieure 74 au contact de la région 78 ; et

- une électrode inférieure conductrice électriquement 82, par exemple métallique, reposant sur la face inférieure 76 au contact du substrat 72.

Selon un mode de réalisation, les faces 74 et 76 sont planes. Selon un mode de réalisation, les faces 74 et 76 sont parallèles. Selon un mode de réalisation, l'épaisseur du substrat 72, c'est-à-dire la distance entre les faces 74 et 76, est comprise entre 60 $\mu$m et 300 $\mu$m, de préférence entre 90 $\mu$m et 300 $\mu$m, plus préférentiellement entre 150 $\mu$m et 300 $\mu$m. La région 78 peut être formée par une étape d'implantation de dopants du deuxième type de conductivité dans le substrat 72.

Pour le dispositif 70 des figures 9 et 10, la concentration de dopants du premier type de conductivité dans le substrat 72 en dehors de la région 78 est sensiblement constante.

Pour le dispositif 70 de la figure 9, le premier type de conductivité est le type N et le deuxième type de conductivité est le type P. La concentration de dopants de type P de la région 78 est comprise entre $1.10^{16}$ at/cm$^3$ et $1.10^{20}$ at/cm$^3$. Selon un mode de réalisation, l'épaisseur maximale de la région 78 est comprise entre 1 $\mu$m et 40 $\mu$m. La concentration de dopants de type N dans le substrat 72 en dehors de la région 78 est comprise entre $2.10^{14}$ at/cm$^3$ et $1.10^{17}$ at/cm$^3$.

Pour le dispositif 70 de la figure 10, le premier type de conductivité est le type P et le deuxième type de conductivité est le type N. La concentration de dopants de type N de la région 78 est comprise entre $1.10^{16}$ at/cm$^3$ et $1.10^{20}$ at/cm$^3$. Selon un mode de réalisation, l'épaisseur maximale de la région 78 est comprise entre 1 $\mu$m et 40 $\mu$m. La concentration de dopants de type P dans le substrat 72 en dehors de la région 78 est comprise entre $2.10^{14}$ at/cm$^3$ et $1.10^{17}$ at/cm$^3$.

Le dispositif 70 représenté sur les figures 9 et 10 se comporte comme la mise en anti-série entre deux bornes d'une diode TVS et d'une diode Schottky. Les bornes correspondent aux électrodes 80 et 82. L'interface entre l'électrode 82 et le substrat 72 faiblement dopé du premier type de conductivité forme la jonction de la diode Schottky. La jonction entre la région 78 dopée du second type de conductivité et la partie du substrat 72 adjacente faiblement dopée du premier type de conductivité forme la jonction de la diode TVS. L'électrode supérieure 80 forme un contact ohmique avec la région 78.

Le dispositif TVS 10 ou 70 peut être utilisé dans n'importe quel circuit électronique comprend un composant électronique devant être protégé contre des pics de tension. Le circuit électronique est par exemple un convertisseur continu-continu, alternatif-continu, ou continu-alternatif fonctionnant dans des conditions de commutation dites dures avec des niveaux de courant élevés.

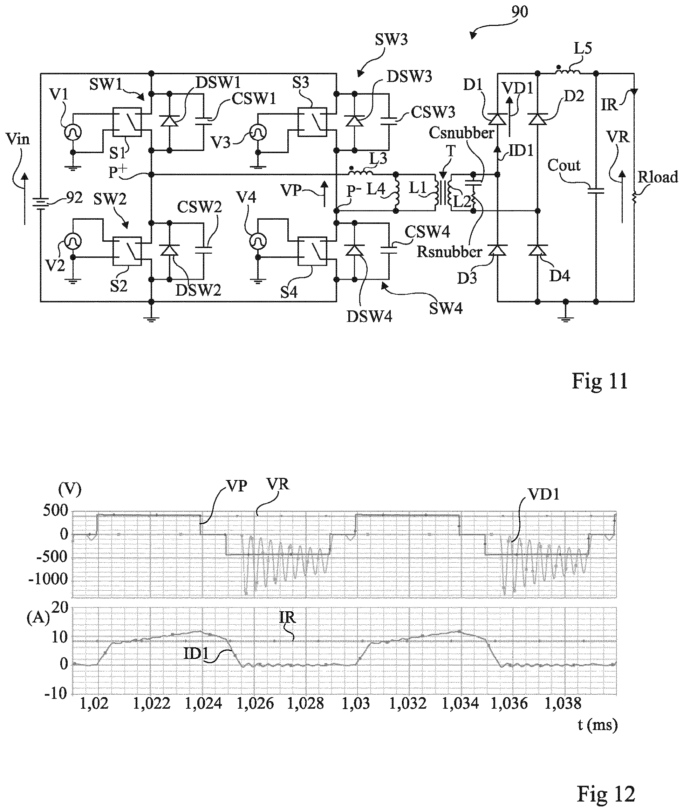

La figure 11 est un schéma électrique d'un exemple de convertisseur 90 de tension continu-continu. Le convertisseur 90 comprend :

- une source 92 d'une tension continue Vin ;

- des premier, deuxième, troisième, et quatrième blocs interrupteurs SW1, SW2, SW3, SW4, chaque bloc interrupteur SW1, SW2, SW3, SW4 comprenant un interrupteur S1, S2, S3, S4, une diode DSW1, DSW2, DSW3, DSW4 montée en parallèle de l'interrupteur, et un condensateur CSW1, CSW2, CSW3, CSW4, monté en parallèle de l'interrupteur, chaque interrupteur S1, S2, S3, S4 étant commandé par le biais d'un coupleur isolé de technologie optique, magnétique ou capacitive par une source V1, V2, V3, V4 d'une tension de commande en créneaux, les premier et deuxième blocs interrupteurs SW1 et SW2 étant montés en série entre les bornes positive et négative de la source 92 de tension et les troisième et quatrième blocs interrupteurs SW3 et SW4 étant montés en série entre les bornes positive et négative de la source 92 de tension ;

- un transformateur T comprenant un enroulement primaire L1 et un enroulement secondaire L2 ;

- une inductance L3 reliant le point milieu P$^+$ entre les premier et deuxième blocs interrupteurs SW1 et SW2 et une première borne de l'enroulement primaire L1, la deuxième borne de l'enroulement primaire L1 étant connecté au point milieu P$^-$ entre les troisième et quatrième blocs interrupteurs SW3 et SW4;

- une inductance L4 en parallèle entre les première et deuxième bornes de l'enroulement primaire L1 ;

- un circuit redresseur à pont de diodes relié à l'enroulement secondaire L2, comprenant une diode D1 dont l'anode est connectée à une première borne de l'enroulement secondaire L2, une diode D2 dont l'anode est connectée à une deuxième borne de l'enroulement secondaire L2, une diode D3 dont la cathode est connectée à la première borne de l'enroulement secondaire L2, et une diode D4 dont la cathode est connectée à la deuxième borne de l'enroulement secondaire L2 ;

- un condensateur Csnubber en série avec une résistance Rsnubber entre les première et deuxième bornes de l'enroulement secondaire L2 ;

- une inductance L5 dont une première borne est connectée à la cathode des diodes D1 et D2 ;

- un condensateur Cout dont une électrode est connectée à la deuxième borne de l'inductance L5 et dont la deuxième électrode est connectée à l'anode des diodes D3 et D4 ; et

- une charge Rload en parallèle du condensateur Cout.

On appelle VP la tension entre le point milieu $P^+$ entre les premier et deuxième blocs interrupteurs SW1 et SW2 et le point milieu $P^-$ entre les troisième et quatrième blocs interrupteurs SW3 et SW4, VD1 la tension entre la cathode et l'anode de la diode D1, VR la tension aux bornes de la résistance Rload, ID1 le courant circulant de l'anode vers la cathode de la diode D1, et IR le courant circulant dans la résistance Rload.

Le condensateur Csnubber et la résistance Rsnubber forme un dispositif de protection contre les surtensions transitoires. Toutefois, pour le circuit électronique 90 représenté en figure 11, les diodes D1, D2, D3, et D4 ne sont pas protégées individuellement par des dispositifs TVS dédiés.

La figure 12 représente des chronogrammes des tensions VP, VD1, et VR, et des courants ID1 et IR obtenues par simulation lors du fonctionnement du convertisseur 90 de la figure 11. Pour cette simulation, la tension Vin est constante est égale à 430 V. Les interrupteurs S1, S2, S3 et S4 sont fermés successivement avec un décalage dans le temps et une synchronisation définie pour permettre une commutation douce au zéro de tension des interrupteurs S1, S2, S3 et S4. Dans l'exemple de la figure 12, sur une période de commutation de 10 $\mu$s, chaque interrupteur S1, S2, S3 et S4 reste fermé pendant 5 $\mu$s puis ouvert pendant 5 $\mu$s.. La tension de sortie VR est sensiblement constante et égale à 360 V. La tension VP varie sensiblement en échelons selon la séquence de fermetures et d'ouvertures des interrupteurs S1, S3, S2, et S4. Lors de l'inversion de la tension VP de +430 V à -430 V (liée à la commutation des interrupteurs S1, S2, S3 et S4), le courant Id1 traversant la diode D1 va décroitre avec une vitesse relativement élevée qui est définie par l'inductance L3 et le rapport de transformation du transformateur T. Lors du passage à zéro du courant Id1, la diode D1 va s'ouvrir entrainant une surtension négative importante et des oscillations parasites de la tension VD1 depuis la valeur de 0 V avec une amplitude maximale de 1350 V, ce qui peut être supérieure à la tension inverse maximale acceptable par la diode D1.

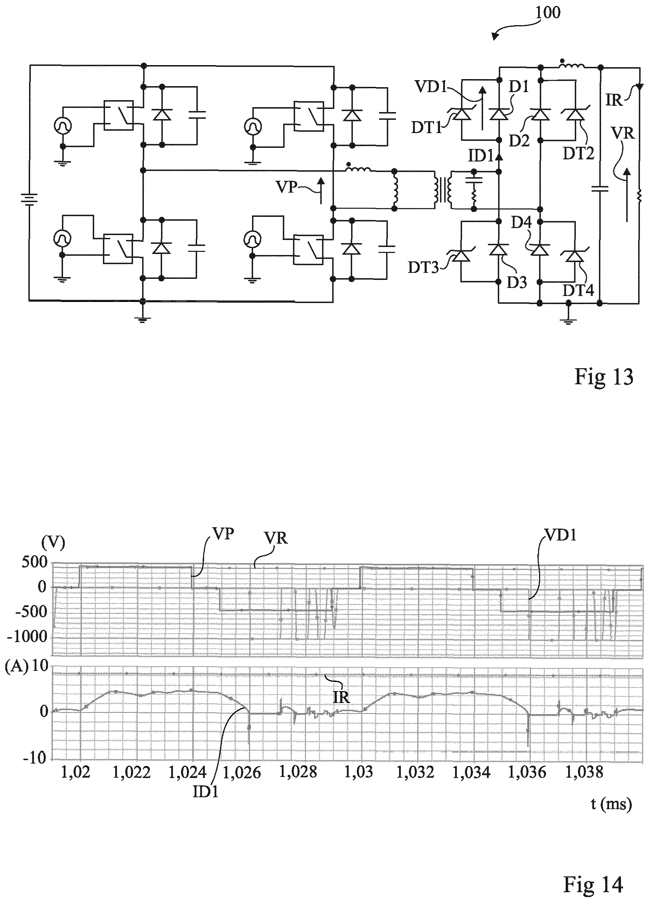

La figure 13 est un schéma électrique d'un convertisseur 100 de tension continu-continu. Le convertisseur 100 comprend l'ensemble des éléments du convertisseur 90 de la figure 11 et comprend, en outre, pour chaque diode Di, i étant un nombre entier variant de 1 à 4, une diode TVS DTi en parallèle de la diode Di, l'anode de la diode TVS DTi étant connectée à l'anode de la diode Di et la cathode de la diode TVS DTi étant connectée à la cathode de la diode Di.

La figure 14 représente des chronogrammes des tensions VP, VD1, et VR, et des courants ID1 et IR obtenues par simulation lors du fonctionnement du convertisseur 100 de la figure 13. Les conditions de fonctionnement sont les mêmes que celles utilisées pour l'obtention des chronogrammes de la figure 12. Les oscillations parasites de la tension VD1 sont écrêtées par la diode TVS DT1. On observe toutefois des différences importantes des courbes d'évolution de la tension VD1 et du courant IR de la figure 14 par rapport aux courbes d'évolution de la tension VD1 et du courant IR de la figure 12 en raison du fait que du courant circule dans chaque diode TVS DT1, DT2, DT3, DT4 lorsqu'elle est polarisée en direct et que des phénomènes de recombinaison de porteurs peuvent se produire.

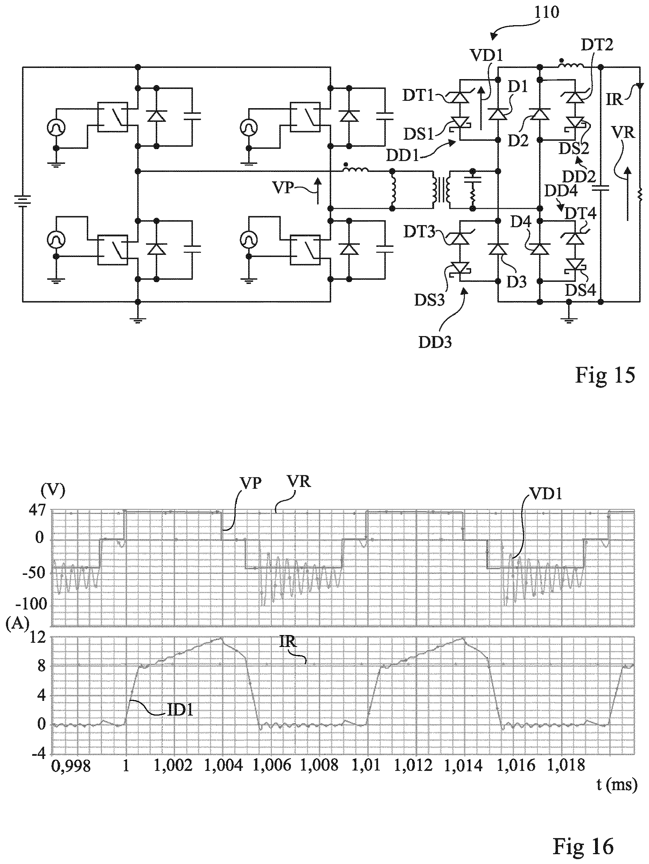

La figure 15 est un schéma électrique d'un convertisseur 110 de tension continu-continu. Le convertisseur 110 comprend l'ensemble des éléments du convertisseur 90 de la figure 11 et comprend, en outre, pour chaque diode Di, i étant un nombre entier variant de 1 à 4, un dispositif TVS DDi ayant la structure du dispositif TVS 10 représenté en figure 1, en parallèle de la diode Di. Chaque dispositif TVS DDi est représenté en figure 15 par la mise en anti-série d'une diode TVS DTi et d'une diode Schottky DSi, la cathode de la Schottky DSi étant connectée à l'anode de la diode Di et la cathode de la diode TVS DTi étant connectée à la cathode de la diode Di.

La figure 16 représente des chronogrammes des tensions VP, VD1, et VR, et des courants ID1 et IR obtenues par simulation lors du fonctionnement du convertisseur 110 de la figure 15. Les conditions de fonctionnement sont les mêmes que celles utilisées pour l'obtention des chronogrammes de la figure 12. Les oscillations parasites de la tension VD1 sont écrêtées. En outre, les courbes d'évolution de la tension VD1 et du courant IR de la figure 16 ont la même allure générale que les courbes d'évolution de la tension VD1 et du courant IR de la figure 12, ce qui signifie que le fonctionnement des diodes D1, D2, D3, et D4 n'est pas perturbé par les dispositifs TVS DDi.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. Enfin, la mise en oeuvre pratique des modes de réalisation et variantes décrits est à la portée de la personne du métier à partir des indications fonctionnelles données ci-dessus.

## Revendications

1. Dispositif de suppression de tensions transitoires (10 ; 70) comprenant un substrat semiconducteur monocristallin dopé d'un premier type de conductivité comprenant des première et deuxième faces opposées (14, 16 ; 74, 76), une région semiconductrice (18 ; 78) dopée d'un deuxième type de conductivité opposé au premier type de conductivité s'étendant dans le substrat depuis la première face, une première électrode conductrice électriquement (20 ; 80) sur la première face en contact avec la première région et une deuxième électrode conductrice électriquement (22 ; 82) sur la deuxième face en contact avec le substrat, une première interface entre le substrat et la région semiconductrice formant la jonction d'une diode TVS et une deuxième interface entre la première électrode conductrice électriquement et la première région ou entre le substrat et la deuxième électrode conductrice électriquement formant la jonction d'une diode Schottky.

2. Dispositif selon la revendication 1, dans lequel la concentration de dopants du deuxième type de conductivité de la région semiconductrice (18) est comprise entre $1.10^{16}$ at/cm$^3$ et $1.10^{17}$ at/cm$^3$ lorsque la deuxième interface est située entre la première électrode conductrice électriquement et la région semiconductrice et la concentration de dopants du deuxième type de conductivité de la région semiconductrice (78) est comprise entre $1.10^{16}$ at/cm$^3$ et $1.10^{20}$ at/cm$^3$ lorsque la deuxième interface est située entre le substrat et la deuxième électrode conductrice électriquement.

3. Dispositif selon la revendication 1 ou 2, dans lequel la concentration de dopants du premier type de conductivité du substrat (12) au niveau de la première interface est comprise entre $2.10^{14}$ at/cm$^3$ et $3.10^{16}$ at/cm$^3$ lorsque la deuxième interface est située entre la première électrode conductrice électriquement et la région semiconductrice et la concentration de dopants du premier type de conductivité du substrat (72) au niveau de la première interface est comprise entre $2.10^{14}$ at/cm$^3$ et $1.10^{17}$ at/cm$^3$ lorsque la deuxième interface est située entre le substrat et la deuxième électrode conductrice électriquement.

4. Dispositif selon l'une quelconque des revendications 1 à 3, dans lequel le substrat comprend un empilement de première et deuxième portions (24, 26), la première portion contenant la région semiconductrice (18) et la deuxième portion étant au contact de la deuxième électrode conductrice électriquement (22), la concentration de dopants du premier type de conductivité de la première portion étant inférieure strictement à la concentration de dopants du premier type de conductivité de la deuxième portion.

5. Circuit électronique (32) comprenant :

   - un support conducteur électriquement (56) ;
   - un composant électronique (30) ayant des première et deuxième bornes (52, 54), la deuxième borne étant fixée au support conducteur électriquement ; et
   - le dispositif de suppression de tensions transitoires (10 ; 70) selon l'une quelconque des revendications 1 à 4, la deuxième électrode conductrice électriquement (22 ; 82) du dispositif de suppression de tensions transitoires étant fixée au support.

6. Circuit électronique selon la revendication 5, dans lequel la première électrode conductrice électriquement (20 ; 80) du dispositif de suppression de tensions transitoires est connectée à la première borne (52) du composant électronique (30).

7. Circuit électronique (110) comprenant au moins un composant électronique (30) et un dispositif de suppression de tensions transitoires (10 ; 70) selon l'une quelconque des revendications 1 à 4, disposé en parallèle du composant électronique.

8. Circuit électronique (110) selon la revendication 7, comprenant au moins quatre composants électroniques (30) montés en pont, et quatre dispositifs de suppression de tensions transitoires (10 ; 70), chaque dispositif de suppression de tensions transitoires (10 ; 70) étant disposé en parallèle de l'un des composants électroniques.

Fig 1

Fig 2

Fig 3

Fig 4

Fig 5

Fig 6

Fig 7

Fig 8

Fig 9

Fig 10

Fig 11

Fig 12

Fig 13

Fig 14

Fig 15

Fig 16

Europäisches
Patentamt

European
Patent Office

Office européen
des brevets

# RAPPORT DE RECHERCHE EUROPEENNE

Numéro de la demande

**EP 22 16 9761**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | CN 103 579 369 A (ZHU JIANG) 12 février 2014 (2014-02-12) * figure 1 et texte associé * ----- | 1-8 | INV. H01L29/872 H01L29/06 H02M3/00 |
| X | US 2018/269313 A1 (BINA MARKUS [DE] ET AL) 20 septembre 2018 (2018-09-20) * figure 2A et texte associé * ----- | 1-8 | H02M1/32 H02M1/34 H02M3/335 H01L25/07  ADD. H01L29/861 |

**DOMAINES TECHNIQUES RECHERCHES (IPC)**

H01L

Le présent rapport a été établi pour toutes les revendications

| Lieu de la recherche | Date d'achèvement de la recherche | Examinateur |
|---|---|---|
| Munich | 23 septembre 2022 | Moehl, Sebastian |

CATEGORIE DES DOCUMENTS CITES

X : particulièrement pertinent à lui seul
Y : particulièrement pertinent en combinaison avec un
autre document de la même catégorie
A : arrière-plan technologique
O : divulgation non-écrite
P : document intercalaire

T : théorie ou principe à la base de l'invention
E : document de brevet antérieur, mais publié à la
date de dépôt ou après cette date
D : cité dans la demande
L : cité pour d'autres raisons
...........................................................................
& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 22 16 9761

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

23-09-2022

| Document brevet cité au rapport de recherche | | Date de publication | Membre(s) de la famille de brevet(s) | | | Date de publication |
|---|---|---|---|---|---|---|
| CN 103579369 | A | 12-02-2014 | AUCUN | | | |
| US 2018269313 | A1 | 20-09-2018 | CN | 108630665 | A | 09-10-2018 |
| | | | CN | 113972271 | A | 25-01-2022 |
| | | | JP | 6643382 | B2 | 12-02-2020 |
| | | | JP | 2018157211 | A | 04-10-2018 |
| | | | US | 2018269313 | A1 | 20-09-2018 |
| | | | US | 2019259863 | A1 | 22-08-2019 |
| | | | US | 2020395472 | A1 | 17-12-2020 |
| | | | WO | 2018172977 | A1 | 27-09-2018 |

EPO FORM P0460

Pour tout renseignement concernant cette annexe : voir Journal Officiel de l'Office européen des brevets, No.12/82